(19)

Europäisches
Patentamt
European
Patent Office
Office européen
des brevets

(11) **EP 3 438 749 A1**

(12) **EUROPEAN PATENT APPLICATION**

(43) Date of publication:
**06.02.2019 Bulletin 2019/06**

(51) Int Cl.:
**G03F 7/20** *(2006.01)*          **G06F 17/50** *(2006.01)*
**G03F 9/00** *(2006.01)*

(21) Application number: **17184214.9**

(22) Date of filing: **01.08.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **ASML Netherlands B.V.
5500 AH Veldhoven (NL)**

(72) Inventors:
• **VAN DIJK, Leon, Paul
5500 AH Veldhoven (NL)**

• **SADEGHINIA, Mahdi
5500 AH Veldhoven (NL)**
• **VAN HAREN, Richard, Johannes, Franciscus
5500 AH Veldhoven (NL)**
• **MALAKHOVSKY, Ilya
5500 AH Veldhoven (NL)**
• **OTTEN, Ronald, Henricus, Johannes
5500 AH Veldhoven (NL)**

(74) Representative: **Peters, John Antoine
ASML Netherlands BV
Corporate Intellectual Property
P.O. Box 324
5500 AH Veldhoven (NL)**

(54) **METHODS OF DETERMINING A MECHANICAL PROPERTY OF A LAYER APPLIED TO A SUBSTRATE, CONTROL SYSTEM FOR A LITHOGRAPHIC APPARATUS AND LITHOGRAPHIC APPARATUS**

(57)     Disclosed is a method for determining a mechanical property of a layer applied to a substrate and associated control system for controlling a lithographic process. The method comprises measuring out-of-plane deformation of the substrate, the out-of-plane deformation comprising deformation normal to a substrate plane defined by, or parallel to, the substrate surface. The measured out-of-plane deformation is fitted to a second order polynomial in two coordinates associated with the substrate plane and the mechanical property (e.g. anisotropic Young's moduli) of the layer is determined based on characteristics of the fitted second order polynomial. The mechanical property of the layer can be used to calibrate an in-plane distortion model of the substrate for predicting in-plane distortion based on the measured out-of-plane deformation.

Fig. 6

EP 3 438 749 A1

**Description**

BACKGROUND

Field of the Invention

0001 The present invention relates to control apparatus and control methods usable, for example, to maintain performance in the manufacture of devices by patterning processes such as lithography. The invention further relates to methods of manufacturing devices using lithographic techniques. The invention yet further relates to computer program products for use in implementing such methods.

Related Art

0002 A lithographic process is one in which a lithographic apparatus applies a desired pattern onto a substrate, usually onto a target portion of the substrate, after which various processing chemical and/or physical processing steps work through the pattern to create functional features of a complex product. The accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. So-called overlay should, in general, be achieved within a few tens of nanometers in today's sub-micron semiconductor devices, down to a few nanometers in the most critical layers.

0003 Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself.

0004 Stress and in-plane distortions of the substrate can, in some cases, be determined via measurements of the shape (e.g., slope) of a clamped or unclamped substrate. Such in-plane distortions may result from one or more stress inducing layers being applied to the substrate. However, inaccuracies in such a determination may result from a failure to account for anisotropy in the stress (and therefore strain) induced by such stress inducing layers.

SUMMARY OF THE INVENTION

0005 The present invention aims to improve systems for control of performance in parameters such as overlay in lithographic processes.

0006 More specifically, the present invention aims to improve measurement of in-plane distortion in a substrate.

0007 According to a first aspect of the present invention, there is provided a method of determining a mechanical property of a layer applied to a substrate, the method comprising: measuring out-of-plane deformation of the substrate, said out-of-plane deformation comprising deformation normal to a substrate plane defined by, or parallel to, the substrate surface; fitting the measured out-of-plane deformation to a second order polynomial in two coordinates associated with the substrate plane; and determining the mechanical property of the layer based on characteristics of the fitted second order polynomial.

0008 According to a second aspect of the present invention, there is provided a control system for controlling a lithographic process, the control system comprising: storage for receiving out-of-plane deformation data describing out-of-plane deformation of the substrate, said out-of-plane deformation comprising deformation normal to a substrate plane defined by, or parallel to, the substrate surface; and a processor operable to: fit the measured out-of-plane deformation to a second order polynomial in two coordinates associated with the substrate plane; determine the mechanical property of the layer based on characteristics of the fitted second order polynomial; and use said determined mechanical property of the layer to calibrate an in-plane distortion model operable to predict in-plane distortion based on measured out-of-plane deformation of the substrate.

0009 The invention yet further provides a lithographic apparatus including a control system according to the second aspect of the invention as set forth above.

0010 The invention yet further provides a computer program product containing one or more sequences of machine-readable instructions for implementing calculating steps in a method according to the first aspect of the invention as set forth above.

0011 These and other aspects and advantages of the apparatus and methods disclosed herein will be appreciated from a consideration of the following description and drawings of exemplary embodiments.

BRIEF DESCRIPTION OF THE DRAWINGS

0012 Embodiments of the invention will now be described, by way of example only, with reference to the accompanying schematic drawings in which corresponding reference symbols indicate corresponding parts, and in which:

Figure 1 depicts a lithographic apparatus suitable for use in an embodiment of the present invention;
Figure 2 depicts a lithographic cell or cluster in which an inspection apparatus according to the present invention may be used;
Figure 3 illustrates schematically measurement and exposure processes in the apparatus of Figure 1, according to known practice;
Figure 4 is a flow diagram describing a method of determining corrections for in-plane distortion of a substrate;
Figure 5 is a representation of (a) example Young's moduli of an isotropic stressed substrate, and (b) example Young's moduli of an anisotropic stressed substrate as may be observed during production;
Figure 6 is a flowchart describing a method according to an embodiment of the invention; and
Figure 7 is a representation of an exemplary measured out-of-plane substrate shape corresponding to the Young's moduli depicted in Figure 5(b).

DETAILED DESCRIPTION OF EXEMPLARY EMBODIMENTS

0013 Before describing embodiments of the invention in detail, it is instructive to present an example environment in which embodiments of the present invention may be implemented.

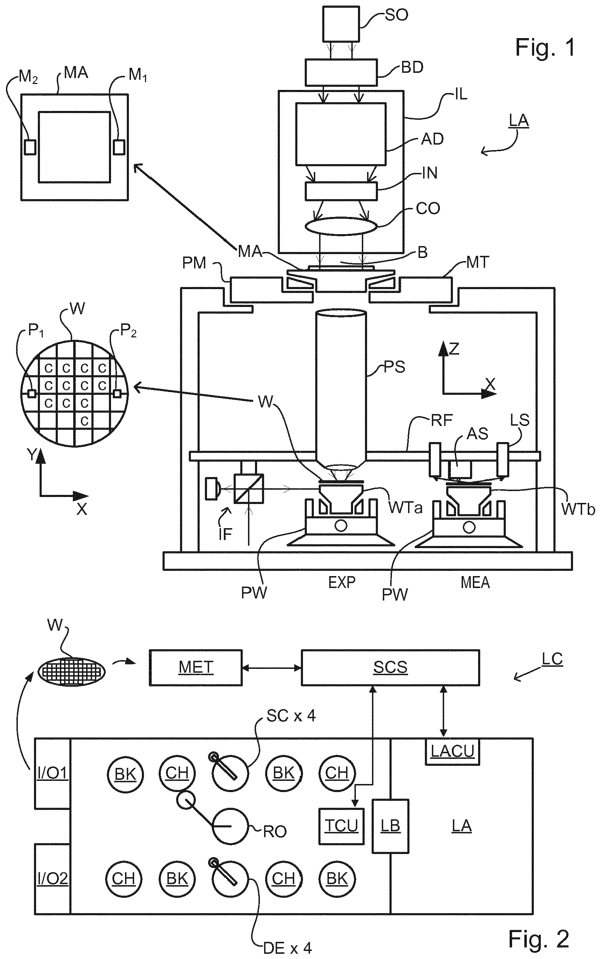

0014 Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

0015 The illumination system may include various types of optical components, such as refractive, reflective, magnetic, electromagnetic, electrostatic or other types of optical components, or any combination thereof, for directing, shaping, or controlling radiation. For example, in an apparatus using extreme ultraviolet (EUV) radiation, reflective optical components will normally be used.

0016 The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

0017 The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

0018 As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

0019 The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

0020 The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

0021 In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

0022 The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

0023 The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

0024 Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers, is described further below.

0025 The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

0026 Combinations and/or variations on the above described modes of use or entirely different modes of use may also be employed.

0027 Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. On a single stage apparatus, the preparatory steps and exposure steps need to be performed sequentially on the single stage, for each substrate. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

0028 As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

0029 In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates.

0030 Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it may be desirable that the inspection apparatus measure properties in the exposed resist layer immediately after the exposure. However, not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

0031 The metrology step with metrology system MET can also be done after the resist pattern has been etched into a product layer. The latter possibility limits the possibilities for rework of faulty substrates but may provide additional information about the performance of the manufacturing process as a whole.

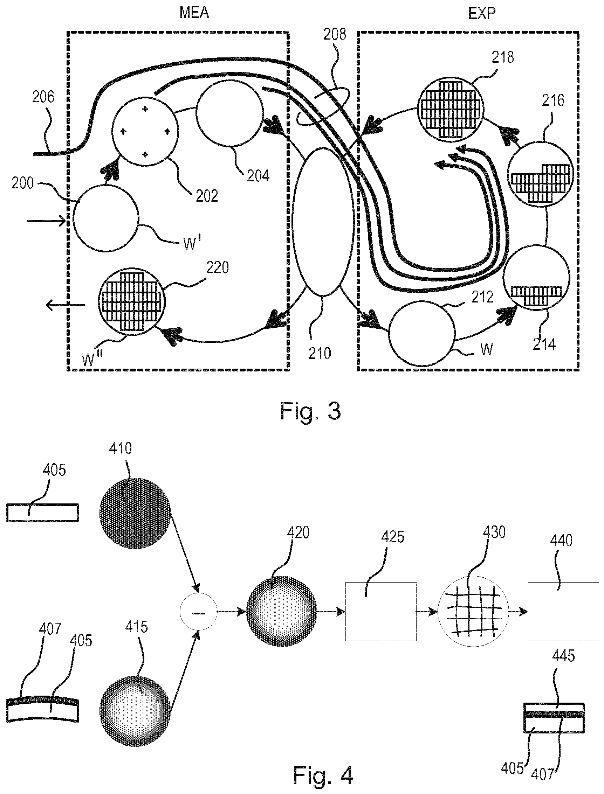

0032 Figure 3 illustrates the steps to expose target portions (e.g. dies) on a substrate W in the dual stage apparatus of Figure 1. The process according to conventional practice will be described first. The present disclosure is by no means limited to dual stage apparatus of the illustrated type. The skilled person will recognize that similar operations are performed in other types of lithographic apparatus, for example those having a single substrate stage and a docking metrology stage.

0033 On the left hand side within a dotted box are steps performed at measurement station MEA, while the right hand side shows steps performed at exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

0034 Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. Each patterning step can introduce positional deviations in the applied pattern, while subsequent processing steps progressively introduce distortions in the substrate and/or the pattern applied to it that must be measured and corrected for, to achieve satisfactory overlay performance.

0035 The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation. Some layers may be patterned by steps that are alternative or supplementary to exposure in the illustrated lithographic apparatus. Such alternative and supplementary techniques include for example imprint lithography, self-aligned multiple patterning and directed self-assembly. Similarly, other processing steps performed per layer (e.g., CMP and etch) may be performed on different apparatuses per layer.

0036 At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a substrate model (sometimes referred to as the "wafer grid"), which maps very accurately the distribution of marks across the substrate, including any distortion relative to a nominal rectangular grid.

0037 At step 204, a map of wafer height (Z) against X-Y position is measured also using the level sensor LS. Primarily, the height map is used only to achieve accurate focusing of the exposed pattern. It may be used for other purposes in addition.

0038 When substrate W' was loaded, recipe data 206 were received, defining the exposures to be performed, and also properties of the wafer and the patterns previously made and to be made upon it. Where there is a choice of alignment marks on the substrate, and where there is a choice of settings of an alignment sensor, these choices are defined in an alignment recipe among the recipe data 206. The alignment recipe therefore defines how positions of alignment marks are to be measured, as well as which marks.

0039 At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns. By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

0040 Substrate distortion may impact overlay performance in a lithographic process. Substrate distortion may result from a thermal treatment of the substrate (e.g. laser anneal) or deposition of stressed thin films. The free-form substrate shape, which can be measured with off-line metrology tools, may change as a result of this distortion. Typical shapes which may be observed in high volume manufacturing are bowl (convex), umbrella (concave), and saddle shapes. Deviations from these shapes result in higher order in-plane distortions. In some cases, these in-plane distortions are slowly spatially varying functions that can be captured by existing alignment models, such as (for example) high order wafer alignment (HOWA) models. An important precondition is that the grid distortions remain global as the polynomial-based HOWA models become less effective for very local distortions. Moreover, alignment marks can get damaged during substrate processing. The resultant inaccuracy in the aligned positions when aligning to such damaged marks cause additional overlay penalties. These penalties become greater when higher-order wafer alignment models are used.

0041 Another approach is to use substrate shape or deformation measurements. Such substrate shape measurements may comprise out-of-plane deformation measurements; i.e., measurements of the shape of the substrate in the z-direction, normal to the substrate surface plane. The substrate shape measurements may comprise measurements of the free-form (unclamped) substrate shape, or may be obtained from measurement of a clamped substrate. Any reference to the substrate shape encompasses any suitable measurement of the out-of-plane deformation of the substrate by any of these, or other, methodologies. Where the relationship between free-form substrate shape and in-plane distortion (IPD) after clamping is known or can be modelled, predictions (and corrections) can be made to improve overlay performance.

0042 Figure 4 conceptually illustrates such a method using a free-form substrate shape measurement according to an embodiment of the invention. Following a layer N exposure 405, the shape (out-of-plane deformation or distortion) of the substrate is measured 410. Subsequent to this, a stressor is added applied to the substrate; for example an applied layer or thin film deposition 407. Thin film stress typically has an impact on the unclamped, free-form shape of the substrate. This stressor results in a change or distortion of the substrate shape. This distorted substrate is again measured 415. The difference 420 of the measured shape of this distorted substrate 415 and the shape of the substrate 410 before stressor application is determined, this difference 420 being the shape change due to stressor application. A prediction model 425 is then used to determine in-plane distortion 430 from the measured shape change 420. Feed-forward corrections 440 for application of layer N+1 445 are determined from the determined in-plane distortion 430. These feed-forward corrections 440 can be used to correct substrate positioning during patterning of layer N+1 445 (and possibly other subsequent layers) on the substrate, thereby improving overlay.

0043 A successful implementation of substrate-shape based feed forward overlay corrections requires that the IPD prediction model 425 provides accurate predictions of the actual distortions. Testing of the IPD prediction models in production settings have shown mixed results with regard to correlation between the measured overlay / alignment residuals and the substrate-shape based IPD predictions. One particular exemplary observation was that the predicted in-plane distortion comprised significant swirl patterns which were not observed in the corresponding measured overlay.

0044 One possible root cause of this absence of correlation is that the IPD prediction model commonly assumes isotropic strain in the thin films applied to the substrate. However such an assumption may not be appropriate. Considering, for example, a typical 20-nm DRAM device pattern, and taking into account the orientation of the printed features and their material properties, it is highly unlikely that the applied film strain will be isotropic.

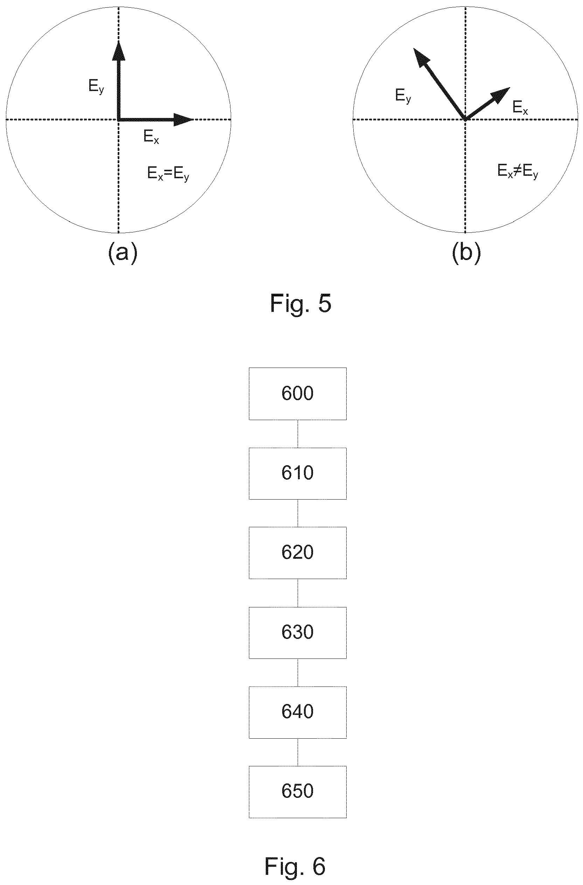

0045 IPD prediction models which take into account anisotropic applied film strain have been proposed. The mechanical properties of both an isotropic and anisotropic stressor can be characterized by the Young's moduli and the orientation of main axes. This is illustrated in Figure 5. Figure 5(a) shows an assumed isotropic layer, where the Young's moduli $E_x$ and $E_y$ are identical (and aligned on the x/y grid). Figure 5(b) shows an anisotropic layer as may actually be observed in a production environment. Here, the Young's moduli $E_x$ and $E_y$ are not equal in magnitude and their main axes have a different orientation relative to the isotropic example of Figure 5(a).

0046 While a particular device pattern may dictate that the IPD prediction model should account for anisotropy in any applied layer, the parameters of the anisotropic applied film stress are not known, nor is there presently any method for determining these parameters without accurate knowledge of the stack. It may be possible to calculate these parameters from first principles. However, this would require very accurate knowledge of the stack, both according to design and also how it is actually imaged on the substrate. This is cumbersome as separate calculations are required for any layer/ product that requires substrate-shape based overlay corrections and, should there be any changes in the stack, the corresponding calculation(s) would need to be redone following each change.

0047 Figure 6 is a flowchart of a method for empirically calibrating an IPD prediction model to account for anisotropic thin film stress, without the need for accurate stack knowledge. The method described in this Figure may comprise a refinement to the method illustrated in Figure 4, for calibrating the IPD prediction model 425. As such, this method may be performed prior to the step of using the IPD prediction model 425 to determine in-plane distortion 430.

0048 In a first step 600, the out-of-plane substrate shape is measured. This may be performed using any suitable method. For example, the difference of the measured shape of the free-form (i.e., unclamped) stressed substrate (with stressor, e.g., thin film applied) and the free-form unstressed (flat) substrate may be determined. As an alternative, the unstressed substrate may simply be assumed to be flat and only the stressed substrate measured. Other suitable methods for determining the substrate shape are equally possible, including those which measure the clamped substrate. This step may be the same as or correspond to steps 410 and 415 of Figure 4.

0049 At step 610, the second order content in the measured substrate shape is determined. This second order content may be found by fitting a second order function to the measured substrate shape data. The second order function may comprise a second order polynomial in two coordinates (x, y) associated with the plane of the substrate. More specifically, in an embodiment, the second order function may take the form of function S (x, *y*), where:

$$S(x, y) = c_{00} + c_{10}x + c_{01}y + c_{20}x^2 + c_{11}xy + c_{02}y^2$$

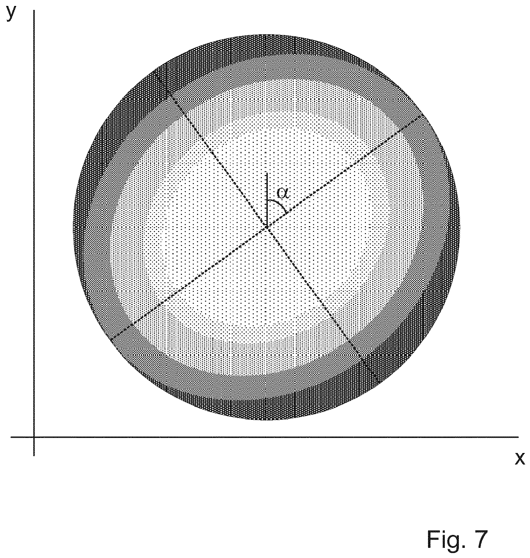

0050 At step 620, the orientation of the two main axes may be determined from the second order shape fit $S(x, y)$. The second order shape fit $S(x, y)$ is not symmetric such that the substrate is distorted more in a first direction than in a second, (e.g., perpendicular) direction. This can originate from anisotropic stress in the top layer, meaning that the Young's moduli are not equal in these directions. Figure 7 shows an example representation of a substrate shape in the x and y directions (in the substrate plane) with the different shading illustrating variation in the z-direction (i.e., height variation). It can be seen that this height variation (warping) is essentially elliptical in shape, and as such the substrate is warped along two main axes tilted by an angle $\alpha$ relative to the y axis. The orientation of the major/minor axes of this elliptical shape may be assumed to correspond with the main axes of the anisotropy being determined. In such a figure, the orientation of the two main axes relative to x and y axes can be clearly observed. In this specific illustrative example, the main axes have been rotated by an angle $\alpha$ of 36 degrees relative to the y axis. It will be readily apparent to the skilled person that this orientation can be derived analytically from the fit parameters.

0051 At step 630, once the orientation of the two main axes has been determined, the ratio of the magnitudes of the relevant mechanical property along the two directions, e.g., Young's moduli $E_x$ and $E_y$, can be derived (see Figure 5(b) which corresponds to the shape illustrated in Figure 7). A pure second order shape can only originate from a constant strain. The Young's moduli will not be equal, and therefore the stress in the layer will also be unequal in the two directions. By calculating the resulting substrate shape after applying a constant strain for the substrate (e.g., a constant strain for an applied film) using the anisotropic IPD model for different ratios of $E_x$ to $E_y$, the optimal $E_x{:}E_y$ ratio can be determined.

The $E_x:E_y$ ratio may be considered optimal when the residual of the predicted second order substrate shape and the fitted second order shape to the measured data, i.e., $S(x,y)$, is minimum. Therefore the Young's moduli $E_x:E_y$ ratio may be determined by minimizing this residual substrate shape over different IPD model predictions corresponding to different ratios of $E_x:E_y$, and selecting the ratio corresponding to this minimum residual.

0052 With the orientation and the Young's moduli $E_x:E_y$ ratio known, the anisotropic IPD prediction model is fully calibrated and characterized. At step 640, the full substrate shape is fed into the calibrated IPD model, and the in-plane distortion calculated (this step corresponding to step 430).

0053 At step 650 (corresponding to step 440), feed-forward corrections are determined from the determined in-plane distortion. These feed-forward corrections can be used to correct substrate positioning during patterning of subsequent layers on the substrate.

0054 It should be noted that only substrate shape data is used in this calibration. No information about the stack is required. Furthermore, the IPD model calibration described is not required for every substrate. The device pattern is the same for every substrate and therefore the overall material properties will be substantially the same as well. Generally, the overall second order shape will be identical for every substrate and it is mostly the deviation from the second order shape which causes substrate-to-substrate variation. Therefore the calibration (steps 610 to 630) may be performed on only a single substrate, and only once per product, with the resulting calibrated IPD model used for all subsequent substrates of that product.

0055 Therefore in summary, an improved, more accurate substrate-shape based IPD prediction model is described in which the model is properly calibrated for anisotropy in any stressor applied to the substrate. This enables improved overlay corrections. The empirical IPD model calibration requires only substrate shape data and overlay data from only one representative substrate only. No details of the process stack is required in order to calibrate the IPD prediction model. In addition, substrate shape based IPD predictions can be used to enrich sparsely available overlay measurement data, such that a denser map of overlay data may be obtained (a method sometimes referred to as "hybrid-metrology" as both direct measurement data and indirectly derived data are combined). An example of such a method is described in US application 62/459,327, incorporated herein by reference.

0056 Further embodiments are disclosed in the list of numbered embodiments below:

1. A method for determining a mechanical property of a layer applied to a substrate, the method comprising: measuring out-of-plane deformation of the substrate, said out-of-plane deformation comprising deformation normal to a substrate plane defined by, or parallel to, the substrate surface; fitting the measured out-of-plane deformation to a second order polynomial in two coordinates associated with the substrate plane; and determining the mechanical property of the layer based on characteristics of the fitted second order polynomial.

2. A method according to embodiment 1, wherein determining said mechanical property of the layer comprises determining the magnitude of said mechanical property in a first direction relative to the magnitude of said mechanical property in a second direction, the second direction comprising at least a component which is perpendicular to the first direction.

3. A method according to embodiment 2, wherein the second direction is perpendicular to the first direction.

4. A method according to embodiment 2 or 3, wherein determining the magnitude of said mechanical property in a first direction relative to the magnitude of said mechanical property in a second direction comprises minimising a difference between the fitted second order polynomial and a modelled substrate shape corresponding to application of a constant strain to the layer, for different ratios of the magnitude of said mechanical property in a first direction to the magnitude of said mechanical property in a second direction.

5. A method according to any of embodiments 2 to 4, further comprising the steps of:

determining an orientation of said first direction and/or said second direction; and
using the determined orientation in said determining the mechanical property of the layer.

6. A method according to embodiment 5, wherein the step of determining the orientation of said first direction and/or said second direction comprises determining the directions of the axes characterising said out-of-plane deformation.

7. A method according to embodiment 6, wherein said out-of-plane deformation substantially defines an elliptical shape in the substrate plane and said first direction and said second direction are defined by the directions of the major and minor axes of said elliptical shape.

8. A method according to any preceding embodiment, wherein said mechanical property of the layer comprises the Young's modulus of the layer.

9. A method according to any preceding embodiment, wherein said layer is an applied stressor layer which stresses and deforms the substrate.

10. A method according to any preceding embodiment, wherein said second order polynomial comprises the form $S(x,y) = c_{00}+c_{10}x+c_{01}y+c_{20}x^2+c_{11}xy+c_{02}y^2$, where x and y are said two coordinates associated with the substrate plane.

11. A method according to any preceding embodiment, comprising using said determined mechanical property of the layer to calibrate an in-plane distortion model operable to predict in-plane distortion based on a measured out-of-plane deformation of the substrate.

12. A method according to embodiment 11, wherein said method is performed and used to calibrate the in-plane distortion model only once based on measurement of out-of-plane deformation from only a single representative substrate, the calibrated in-plane distortion model being used to predict in-plane distortion for subsequent substrates on which the same product structure is to be applied as that applied to the single representative substrate.

13. A method according to embodiment 11 or 12, comprising:

using said in-plane distortion model to predict in-plane distortion based on measured out-of-plane deformation of the substrate; and
using said predicted in-plane distortion to determine corrections for one or more subsequent production steps on said substrate.

14. A control system for controlling a lithographic process, the control system comprising:

storage for receiving out-of-plane deformation data describing out-of-plane deformation of the substrate, said out-of-plane deformation comprising deformation normal to a substrate plane defined by, or parallel to, the substrate surface; and
a processor operable to:

fit the measured out-of-plane deformation to a second order polynomial in two coordinates associated with the substrate plane;
determine the mechanical property of the layer based on characteristics of the fitted second order polynomial; and
use said determined mechanical property of the layer to calibrate an in-plane distortion model operable to predict in-plane distortion based on measured out-of-plane deformation of the substrate.

15. A control system according to embodiment 14, wherein said processor is operable to determine said mechanical property of the layer by determining the magnitude of said mechanical property in a first direction relative to the magnitude of said mechanical property in a second direction, the second direction being perpendicular to the first direction.

16. A control system according to embodiment 15, wherein the second direction is perpendicular to the first direction.

17. A control system according to embodiment 15 or 16, wherein said processor is operable to determine the magnitude of said mechanical property in a first direction relative to the magnitude of said mechanical property in a second direction by minimising a difference between the fitted second order polynomial and a modelled substrate shape corresponding to application of a constant strain to the layer, for different ratios of the magnitude of said mechanical property in a first direction to the magnitude of said mechanical property in a second direction.

18. A control system according to any of embodiments 15 to 17, wherein said processor is operable to determine an orientation of said first direction and/or said second direction, and use the determined orientation in determining said mechanical property of the layer.

19. A control system according to embodiment 18, wherein the determination of the orientation of said first direction and/or said second direction comprises a determination of the directions of the axes characterising said out-of-plane deformation.

20. A control system according to embodiment 19, wherein said out-of-plane deformation substantially defines an elliptical shape in the substrate plane and said first direction and said second direction are defined by the directions of the major and minor axes of said elliptical shape.

21. A control system according to any of embodiments 14 to 20, wherein said mechanical property of the layer comprises the Young's modulus of the layer.

22. A control system according to any of embodiments 14 to 21, wherein said layer is an applied stressor layer which stresses and deforms the substrate.

23. A control system according to any of embodiments 14 to 22, wherein said second order polynomial comprises the form $S(x, y) = c_{00} + c_{10}x + c_{01}y + c_{20}x^2 + c_{11}xy + c_{02}y^2$, where x and y are said two coordinates associated with the substrate plane.

24. A control system according to any of embodiments 14 to 23, wherein the processor is operable to calibrate the in-plane distortion model only once based on measurement of out-of-plane deformation from only a single representative substrate, the control system being further operable to use the calibrated in-plane distortion model to predict in-plane distortion for subsequent substrates on which the same product structure is to be applied as that applied to the single representative substrate.

25. A control system according to any of embodiments 14 to 24, wherein said processor is further operable to:

use said in-plane distortion model to predict in-plane distortion based on measured out-of-plane deformation of the substrate; and
use said predicted in-plane distortion to determine corrections for one or more subsequent production steps on said substrate.

26. A lithographic apparatus comprising:

the control system according to embodiment 25; and
a patterning system being operable to form device features on said substrate in a patterning process using said determined corrections.

27. A computer program product containing one or more sequences of machine-readable instructions for implementing the steps of a method of any of embodiments 1 to 13.

28. A computer program product containing one or more sequences of machine-readable instructions for causing a processing device or system of processing devices to implement the control system of any of embodiments 14 to 25.

0057 In association with the hardware of the lithographic apparatus and the lithocell LC, an embodiment may include a computer program containing one or more sequences of machine-readable instructions for causing the processors of the lithographic manufacturing system to implement methods of model mapping and control as described above. This computer program may be executed for example in a separate computer system employed for the image calculation/control process. Alternatively, the calculation steps may be wholly or partly performed within a processor a metrology tool, and/or the control unit LACU and/or supervisory control system SCS of Figures 1 and 2. There may also be provided a data storage medium (e.g., semiconductor memory, magnetic or optical disk) having such a computer program stored therein in non-transient form.

0058 Although specific reference may have been made above to the use of embodiments of the invention in the context of optical lithography, it will be appreciated that the invention may be used in other patterning applications, for example imprint lithography. In imprint lithography, topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

0059 The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

0060 The breadth and scope of the present invention should not be limited by any of the above-described exemplary embodiments, but should be defined only in accordance with the following claims and their equivalents.

**Claims**

1. A method for determining a mechanical property of a layer applied to a substrate, the method comprising:

measuring out-of-plane deformation of the substrate, said out-of-plane deformation comprising deformation normal to a substrate plane defined by, or parallel to, the substrate surface;
fitting the measured out-of-plane deformation to a second order polynomial in two coordinates associated with the substrate plane; and determining the mechanical property of the layer based on characteristics of the fitted second order polynomial.

2. A method as claimed in claim 1, wherein determining said mechanical property of the layer comprises determining the magnitude of said mechanical property in a first direction relative to the magnitude of said mechanical property in a second direction, the second direction comprising at least a component which is perpendicular to the first direction.

3. A method as claimed in claim 2, wherein the second direction is perpendicular to the first direction.

4. A method as claimed in claim 2 or 3, wherein determining the magnitude of said mechanical property in a first direction relative to the magnitude of said mechanical property in a second direction comprises minimising a difference between the fitted second order polynomial and a modelled substrate shape corresponding to application of a constant strain to the layer, for different ratios of the magnitude of said mechanical property in a first direction to the magnitude of said mechanical property in a second direction.

5. A method as claimed in any of claims 2 to 4, further comprising the steps of:

    determining an orientation of said first direction and/or said second direction; and
    using the determined orientation in said determining the mechanical property of the layer.

6. A method as claimed in claim 5, wherein the step of determining the orientation of said first direction and/or said second direction comprises determining the directions of the axes characterising said out-of-plane deformation.

7. A method as claimed in claim 6, wherein said out-of-plane deformation substantially defines an elliptical shape in the substrate plane and said first direction and said second direction are defined by the directions of the major and minor axes of said elliptical shape.

8. A method as claimed in any preceding claim, wherein said mechanical property of the layer comprises the Young's modulus of the layer.

9. A method as claimed in any preceding claim, wherein said layer is an applied stressor layer which stresses and deforms the substrate.

10. A method as claimed in any preceding claim, wherein said second order polynomial comprises the form $S(x, y) = c_{00} + c_{10}x + c_{01}y + c_{20}x^2 + c_{11}xy + c_{02}y^2$, where x and y are said two coordinates associated with the substrate plane.

11. A method as claimed in any preceding claim, comprising using said determined mechanical property of the layer to calibrate an in-plane distortion model operable to predict in-plane distortion based on a measured out-of-plane deformation of the substrate.

12. A method as claimed in claim 11, wherein said method is performed and used to calibrate the in-plane distortion model only once based on measurement of out-of-plane deformation from only a single representative substrate, the calibrated in-plane distortion model being used to predict in-plane distortion for subsequent substrates on which the same product structure is to be applied as that applied to the single representative substrate.

13. A method as claimed in claim 11 or 12, comprising:

    using said in-plane distortion model to predict in-plane distortion based on measured out-of-plane deformation of the substrate; and
    using said predicted in-plane distortion to determine corrections for one or more subsequent production steps on said substrate.

14. A control system for controlling a lithographic process, the control system comprising:

    storage for receiving out-of-plane deformation data describing out-of-plane deformation of the substrate, said out-of-plane deformation comprising deformation normal to a substrate plane defined by, or parallel to, the substrate surface; and
    a processor operable to:

        fit the measured out-of-plane deformation to a second order polynomial in two coordinates associated with the substrate plane;
        determine the mechanical property of the layer based on characteristics of the fitted second order polynomial; and

use said determined mechanical property of the layer to calibrate an in-plane distortion model operable to predict in-plane distortion based on measured out-of-plane deformation of the substrate.

15. A control system as claimed in claim 14, wherein said processor is operable to determine said mechanical property of the layer by determining the magnitude of said mechanical property in a first direction relative to the magnitude of said mechanical property in a second direction, the second direction being perpendicular to the first direction.

Fig. 1

Fig. 2

MEA

EXP

206

200

202

204

208

W'

220

W"

210

218

216

212

214

W

## Fig. 3

405

410

407 405

415

420

425

430

440

445

405 407

## Fig. 4

$E_y$

$E_x$

$E_x = E_y$

(a)

$E_y$

$E_x$

$E_x \neq E_y$

(b)

Fig. 5

600

610

620

630

640

650

Fig. 6

Fig. 7

Europäisches
Patentamt

European
Patent Office

Office européen
des brevets

# EUROPEAN SEARCH REPORT

Application Number

EP 17 18 4214

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2008/182344 A1 (MUELLER STEFFEN [DE] ET AL) 31 July 2008 (2008-07-31) <br> * paragraph [0023]; figure 1 * <br> * paragraphs [0030] - [0051]; figures 2,3 * | 1-15 | INV. <br> G03F7/20 <br> G06F17/50 <br> G03F9/00 |
| Y | US 2016/357100 A1 (IKUTA YOSHIAKI [JP]) 8 December 2016 (2016-12-08) <br><br> * paragraphs [0009] - [0012] * <br> * paragraphs [0020] - [0022] * <br> * paragraph [0086]; figure 1 * | 1-4, 8-10,14, 15 | |
| Y | US 8 645 086 B1 (CASTLE JAMES B [US] ET AL) 4 February 2014 (2014-02-04) <br> * column 1, line 25 - column 3, line 42 * <br> * column 9, line 3 - column 15, line 38; figures 2,2A,6,10A-C * | 5-7, 11-13 | |
| Y | EP 1 744 217 A1 (ASML NETHERLANDS BV [NL]) 17 January 2007 (2007-01-17) <br> * paragraphs [0030] - [0036] * | 5,6 | TECHNICAL FIELDS SEARCHED (IPC) |
| A | VAN DIJK LEON ET AL: "Wafer-shape based in-plane distortion predictions using superfast 4G metrology", PROCEEDINGS OPTICAL DIAGNOSTICS OF LIVING CELLS II, SPIE, US, vol. 10145, 28 March 2017 (2017-03-28), pages 101452L-101452L, XP060087851, ISSN: 0277-786X, DOI: 10.1117/12.2257475 ISBN: 978-1-5106-1324-9 * 3. Results * | 1-15 | G03F <br> G06F |

The present search report has been drawn up for all claims

| Place of search | Date of completion of the search | Examiner |
|---|---|---|
| Munich | 6 February 2018 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 18 4214

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2018

| Patent document cited in search report | | Publication date | Patent family member(s) | | Publication date |
|---|---|---|---|---|---|
| US 2008182344 | A1 | 31-07-2008 | DE 102007007697 A1<br>US 2008182344 A1 | | 31-07-2008<br>31-07-2008 |
| US 2016357100 | A1 | 08-12-2016 | JP 2017003977 A<br>KR 20160144312 A<br>TW 201704851 A<br>US 2016357100 A1 | | 05-01-2017<br>16-12-2016<br>01-02-2017<br>08-12-2016 |
| US 8645086 | B1 | 04-02-2014 | NONE | | |
| EP 1744217 | A1 | 17-01-2007 | CN 1916770 A<br>EP 1744217 A1<br>JP 4740057 B2<br>JP 5208981 B2<br>JP 2007027721 A<br>JP 2010123997 A<br>KR 20070008427 A<br>SG 129366 A1<br>TW 200710596 A<br>US 2007021860 A1 | | 21-02-2007<br>17-01-2007<br>03-08-2011<br>12-06-2013<br>01-02-2007<br>03-06-2010<br>17-01-2007<br>26-02-2007<br>16-03-2007<br>25-01-2007 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62459327 B